# EUROPEAN PATENT APPLICATION

(11) **EP 4 492 366 A1**
(43) Date of publication of application: **15.01.2025**
(21) Application number: 22931628.6
(22) Date of filing: 10.06.2022
(51) Int. Cl.: G09G 3/32

(54) **DISPLAY PANEL VIRTUAL PIXEL REUSING STRUCTURE, AND CONTROL METHOD AND SYSTEM**

(30) Priority: 18.03.2022 CN 202210269705
(71) Applicant: Changchun Cedar Electronics Technology Co., Ltd, Changchun, Jilin 130103 (CN)
(72) Inventor: ZHENG, Xifeng, Changchun, Jilin 130103 (CN); WANG, Ruiguang, Changchun, Jilin 130103 (CN); WANG, Yang, Changchun, Jilin 130103 (CN); XING, Fanyang, Changchun, Jilin 130103 (CN); LIU, Yanmei, Changchun, Jilin 130103 (CN); CHEN, Yu, Changchun, Jilin 130103 (CN); CAO, Hui, Changchun, Jilin 130103 (CN)
(74) Representative: Ipside
(86) International application number: PCT/CN2022/098037
(87) International publication number: WO 2023/173604

(57) **Abstract**

The invention discloses a subpixel arrangement structure, a control method and a control system of a display panel, belongs to the technical field of control of display panels, and solves the problems of single subpixel arrangement mode and difficulty in color matching of an arrangement mode in the prior art. A display panel in the multiplexing structure is of an array structure composed of multiple light-emitting components, a distance between two adjacent light-emitting components in a same row is one basic unit, the light-emitting components in adjacent rows and a same column are staggered by a half basic unit, and the adjacent light-emitting components in any direction are light-emitting components with different primary colors. Three adjacent light-emitting components with three primary colors form a pixel unit, and a condition that multiple pixel units multiplex a same light-emitting component exists. In the control method, the drive signal of the multiplexed light-emitting component is an average value of the drive signals corresponding to multiple pixel units multiplexing the light-emitting component. The structure and method of the invention are suitable for the technical field of manufacturing and control of display panels, and particularly suitable for the technical field of control of LED display panels.

## Description

### Technical Field

The invention belongs to the technical field of display panel control, and specifically relates to the technical field of a subpixel arrangement structure and control of a display panel.

### Background of the Invention

At present, high-density and small-pitch LED, Mini LED and Micro LED display technologies have become hot topics in new display industries, and the display effect of products has also become a common focus of attention for users and industries. Without considering brightness, contrast, stability and uniformity, main factors affecting the image clarity of high-density LED display screens include an image space resolution, an image display level resolution, a degree of optical crosstalk of pixels, a degree of fusion of image edges, and the like, where the image space resolution in LED display is equivalent to the arrangement density of LED pixels.

The patent document CN1892745A discloses "a method for improving the image resolution of a display screen by pixel multiplexing". In the invention, LED primary color tube cores are uniformly arranged in the form of a right angle on a panel. For this display panel, in addition to taking an unconventional approach in arrangement, a virtual pixel control technology is also used in control, which can achieve four-times multiplexing of each primary color sub-pixel. The control mode of the invention is to calculate an average value through arithmetic, but a virtual pixel control method for an arrangement mode of a right triangle can only be four-times subpixel arrangements. The patent document CN103325320A discloses "an LED display screen with diagonal arrangement of chips with a same color, and a pixel multiplexing method". In the invention, LED primary color tube cores are uniformly arranged in the form of a square on a panel. Similarly, the control mode of the invention achieves three-times and six-times subpixel arrangements by calculating an average value through arithmetic. However, due to the unequal number of three primary colors in this arrangement mode, difficulty in color matching is caused.

Based on the above factors, the prior art has the following defects:
1) The arrangement mode of a right triangle may cause the problem of single and inflexible subpixel arrangement mode; and
2) The arrangement mode of a square may cause the problem of difficulty in color matching due to the unequal number of three primary colors.

### Summary of the Invention

The invention solves the problems of single subpixel arrangement mode and difficulty in color matching of an arrangement mode in the prior art.

In order to solve the above problems, the invention provides the following solutions:
Solution 1: A subpixel arrangement structure of a display panel is provided, where the display panel is of an array structure composed of multiple light-emitting components, a distance between two adjacent light-emitting components in a same row is one basic unit, the light-emitting components in adjacent rows and a same column are staggered by a half basic unit, and the adjacent light-emitting components in any direction are light-emitting components with different primary colors; and
three adjacent light-emitting components with three primary colors form a pixel unit, and a condition that multiple pixel units multiplex a same light-emitting component exists.

Further, the light-emitting component is a single illuminant or a combination of multiple illuminants with a same color.

Further, the illuminant is any one of an LED, an OLED, or an LCD.

Solution 2: A subpixel arrangement structure of a display panel is provided, where the light-emitting components in three adjacent rows form two rows of pixel units, and each pixel unit is a triangle composed of three light-emitting components with three primary colors in two adjacent rows, where one row of pixel units are regular triangles, and adjacent base angles of two adjacent triangles share one light-emitting component; the other row of pixel units are inverted triangles, and adjacent base angles of two adjacent triangle pixel units share one light-emitting component; and
vertex angles of each pixel unit of a regular triangle and an adjacent pixel unit of an inverted triangle in a previous row share one light-emitting component, and two base angles of the pixel unit of a regular triangle and a pixel unit of an inverted triangle in a next row respectively share one light-emitting component.

Solution 3: A subpixel arrangement structure of a display panel is provided, where any adjacent light-emitting components with three primary colors form a pixel unit; and when the multiple light-emitting components are arranged in i rows and j columns, pixel units in i rows and 2j columns are formed.

Solution 4: A subpixel arrangement control method of a display panel is provided, where the control method is implemented for the subpixel arrangement structure according to the solution 1, and the control method includes:
dividing an image to be displayed into corresponding pixel blocks according to distribution of pixel units of the display panel;
acquiring drive signals of light-emitting components with three primary colors in each pixel unit according to color and brightness of the pixel block corresponding to the pixel unit so that multiple drive signals of the light-emitting components to be multiplexed by multiple pixel units are provided, and taking an average value of the multiple drive signals as an actual drive signal of the light-emitting component; and
transmitting all drive signals by scanning to complete a display of an image.

Solution 5: A computer-readable storage medium is provided, where the computer-readable storage medium is configured to store a computer program, and the computer program executes the subpixel arrangement control method according to the solution 4.

Solution 6: An electronic device is provided, including a processor and a memory, where the memory is configured to store a computer program; and the processor is configured to implement the subpixel arrangement control method according to the solution 4 when executing the computer program stored in the memory.

Solution 7: A subpixel arrangement control system is provided, where the control system includes the display panel, a control unit and a drive unit, the display panel is of the subpixel arrangement structure according to the solution 1, the drive unit is configured to perform display driving of the display panel according to a drive signal transmitted by the control unit, a module implemented by computer software is embedded inside the control unit, and the module includes:
an image collection module, configured to collect an image to be displayed;
a pixel block division module, configured to divide the image to be displayed into corresponding pixel blocks according to distribution of pixel units of the display panel;
a drive signal acquisition module, configured to acquire drive signals of light-emitting components with three primary colors in each pixel unit according to color and brightness of the pixel block corresponding to the pixel unit;
a multiplexed light-emitting component drive signal adjusting module, configured to take an average value of multiple drive signals corresponding to the light-emitting component multiplexed by multiple pixel units as an actual drive signal of the light-emitting component; and
a drive signal transmission module, configured to transmit all drive signals of the light-emitting components to the drive unit.

The invention solves the problems of single subpixel arrangement mode and difficulty in color matching of an arrangement mode in the prior art. Specific beneficial effects include:
1. In the subpixel arrangement structure of the display panel of the invention, the arrangement structure of pixel units is a staggered arrangement mode of regular triangles and inverted triangles, the arrangement is tight, the drive signal of the light-emitting component is calculated by taking an average value, and three-times and six-times subpixel arrangements can be achieved. The subpixel arrangement mode in this arrangement mode is relatively flexible, and different multiplexing modes can be freely switched when a same lamp panel is used, thereby solving the problem of single subpixel arrangement of right triangles.
2. In the subpixel arrangement structure of the display panel of the invention, in the arrangement of light-emitting components, the number of red, green, and blue light-emitting components is uniform, each accounting for 1/3 of the total number, which makes color matching more uniform, thereby solving the problem of difficulty in color matching in the arrangement mode of the prior art due to the unequal number of red, green, and blue light-emitting components, where the number of red and blue light-emitting components is respectively 1/4 of the total number, and the number of green light-emitting components is 1/2 of the total number.
3. In the subpixel arrangement structure of the display panel of the invention, a pixel unit is composed of three light-emitting components with three primary colors that form a triangle, the resolution of each color is consistent, and the resolution loss is small when a red/blue picture is displayed, thereby solving the problem of low brightness when the red/blue picture is displayed due to the unequal number of three primary colors in the existing square arrangement mode.

The subpixel arrangement structure of the display panel of the invention is suitable for small, medium, and large display screens and control thereof, and is particularly suitable for the technical field of LED, Mini LED, and Micro LED display.

### Brief Description of the Drawings

The above and/or additional aspects and advantages of the invention will become obvious and easy to understand from the descriptions of examples with reference to the accompanying drawings. In the figures:
FIG. 1 is a schematic diagram of an array structure composed of multiple light-emitting components in embodiment 1, where 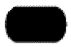 represents a red light-emitting component; 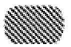 represents a green light-emitting component; and 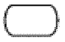 represents a blue light-emitting component.
FIG. 2 is a schematic diagram of pixel unit distribution corresponding to a three-times virtual technology in embodiment 1.
FIG. 3 is a schematic diagram of positions of pixel units in the three-times virtual technology in embodiment 1. The circled numbers in the figure represent corresponding pixel units. For example, ⑪ represents a pixel unit L (1, 1) in the first row and the first column, and the position of the circled number is a display centre of the pixel unit.
FIG. 4 is a schematic diagram of pixel unit distribution corresponding to a six-times virtual technology in embodiment 3. The circled numbers in the figure represent corresponding pixel units. For example, ⑪ represents a pixel unit L (1, 1) in the first row and the first column, and the position of the circled number is a schematic diagram of a display centre of the pixel unit.
FIG. 5 is a schematic diagram of a multiplexing state of a light-emitting component that is multiplexed six times in the six-times virtual technology in embodiment 3, where pixel units C1 to C6 multiplex one light-emitting component.

### Detailed Description of Embodiments

Various embodiments of the invention are clearly and completely described below with reference to the accompanying drawings. The examples described with reference to the accompanying drawings are exemplary, and are intended to explain the invention, but should not be understood as a limitation on the invention.

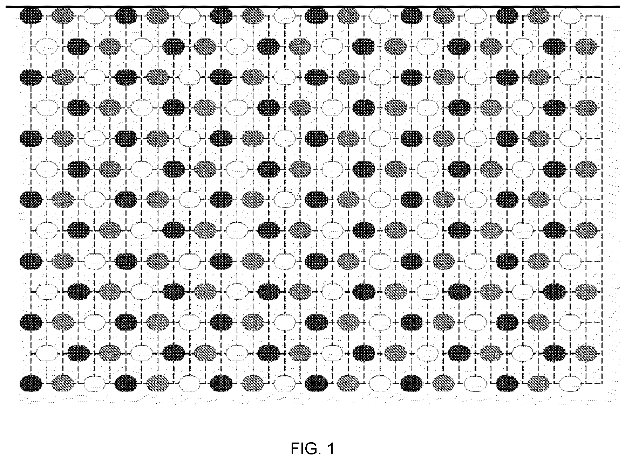

Embodiment 1: This embodiment is described with reference to FIG. 1 to FIG. 3. This embodiment describes a subpixel arrangement structure of a display panel. The display panel is of an array structure composed of multiple light-emitting components, a distance between two adjacent light-emitting components in a same row is one basic unit, the light-emitting components in adjacent rows and a same column are staggered by a half basic unit, and the adjacent light-emitting components in any direction are light-emitting components with different primary colors; and
three adjacent light-emitting components with three primary colors form a pixel unit, and a condition that multiple pixel units multiplex a same light-emitting component exists.

The light-emitting component is a single illuminant or a combination of multiple illuminants with a same color.

The illuminant is any one of an LED, an OLED, or an LCD.

In the multiplexing structure of this embodiment, the arrangement mode of light-emitting components is shown in FIG. 1, the light-emitting components in a same row are arranged alternately according to three primary colors, and all light-emitting components on a same diagonal line are also arranged alternately according to three primary colors; and
three adjacent light-emitting components with three primary colors form a pixel unit, and a condition that multiple pixel units multiplex a same light-emitting component exists. This structure can effectively avoid the occurrence of single subpixel arrangement mode and difficulty in color matching, and this multiplexing structure of pixel units can achieve three-times and six-times subpixel arrangements.

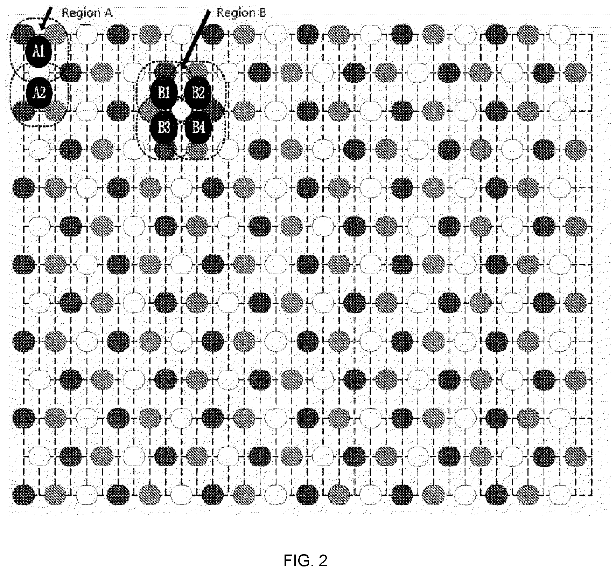

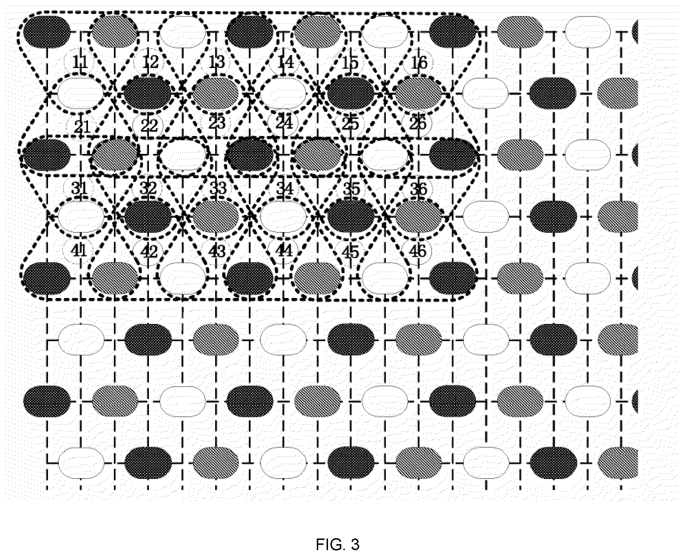

Embodiment 2: This embodiment is described with reference to FIG. 2 and FIG. 3. This embodiment further defines the subpixel arrangement structure of the display panel in embodiment 1. In this embodiment, the light-emitting components in three adjacent rows form two rows of pixel units, and each pixel unit is a triangle composed of three light-emitting components with three primary colors in two adjacent rows, where one row of pixel units are regular triangles, and adjacent base angles of two adjacent triangles share one light-emitting component; the other row of pixel units are inverted triangles, and adjacent base angles of two adjacent triangle pixel units share one light-emitting component; and
vertex angles of each pixel unit of a regular triangle and an adjacent pixel unit of an inverted triangle in a previous row share one light-emitting component, and two base angles of the pixel unit of a regular triangle and a pixel unit of an inverted triangle in a next row respectively share one light-emitting component.

In this embodiment, the light-emitting components in the display panel are arranged in a diagonal cross structure, and the pixel units are designed based on the principle of a two-times virtual technology. Referring to FIG. 2 and FIG. 3, in this structure, the light-emitting component in the first row and the first column is denoted as D (1, 1), the light-emitting component in the first row and the second column is denoted as D (1, 2), and so on. The light-emitting components in adjacent rows and a same column are staggered by a half basic unit.

In this arrangement mode, adjacent light-emitting components with three primary colors form a triangular structure as a pixel unit, a centre of the shown triangular structure is a display centre, and a position thereof corresponds to the corresponding pixel block in the image to be displayed.

In this structure, the corresponding relationship between a pixel unit y and a light-emitting component is: when i is an odd number, the light-emitting component D (i, j) in the i^{th} row and the j^{th} column, the light-emitting component D (i, j+1) in the i^{th} row and the j+1^{th} column, and the light-emitting component D (i+1, j) in the i+1^{th} row and the j^{th} column form a pixel unit L (i, j) of an inverted triangle in the i^{th} row and the j^{th} column; and
when i is an even number, the light-emitting component D (i, j) in the i^{th} row and the j^{th} column, the light-emitting component D (i+1, j) in the i+1^{th} row and the j^{th} column, and the light-emitting component D (i+1, j+1) in the i+1^{th} row and the j+1^{th} column form a pixel unit L (i, j) of a regular triangle in the i^{th} row and the j^{th} column.

Referring to FIG. 3, ⑪ is a pixel unit L (1, 1) of an inverted triangle, ⑫ is a pixel unit L (1, 2) of an inverted triangle, etc. The pixel unit L (1, 1) and the pixel unit L (1, 2) share one light-emitting component D (1, 2). 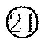 is a pixel unit L (2, 1) of a regular triangle, and the pixel unit L (2, 1) and the pixel unit L (1, 1) in a previous row share light-emitting component D (2, 1). 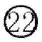 is a pixel unit L (2, 2) of a regular triangle, the pixel unit L (2, 2) and the pixel unit L (1, 2) in a previous row share light-emitting component D (2, 2), the pixel unit L (2, 2) and the adjacent pixel unit L (2, 1) share light-emitting component D (3, 2), and the pixel unit L (2, 2) and the pixel unit L (3, 2) of an inverted triangle in a next row share light-emitting components D (3, 2) and D (3, 3) at the positions of two base angles. In this way, the maximum multiplexing number is four. For example, the light-emitting component D (3, 3) is multiplexed by the pixel units L (2, 2), L (2, 3), L (3, 2) and L (3, 3).

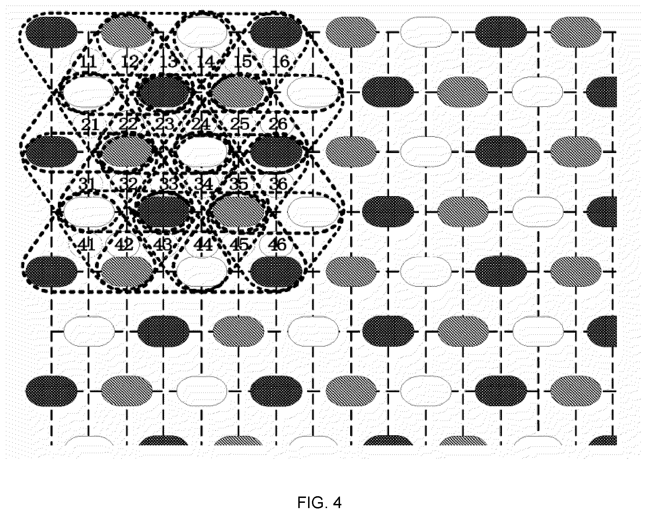

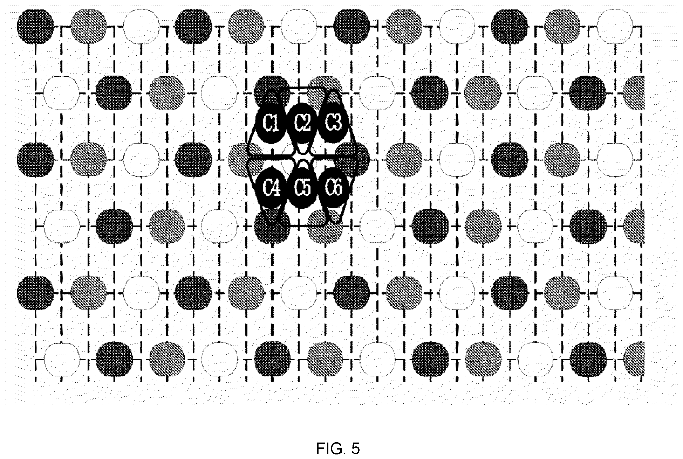

Embodiment 3: This embodiment is described with reference to FIG. 4 and FIG. 5. This embodiment further defines the subpixel arrangement structure of the display panel in embodiment 1. In this embodiment, any adjacent light-emitting components with three primary colors form a pixel unit; and when the multiple light-emitting components are arranged in i rows and j columns, pixel units in i rows and 2j columns are formed.

The difference between this embodiment and embodiment 2 is that the definition of pixel units is different. In this embodiment, any adjacent light-emitting components with three primary colors form a pixel unit, and pixel units in i rows and 2j columns are formed, so that the arrangement of pixel units in this embodiment is tighter than that in embodiment 2. Referring to FIG. 4, the pixel units in a same row are arranged alternately according to regular triangles and inverted triangles, and the pixel units in a same column are also arranged alternately according to regular triangles and inverted triangles. For example,
⑪ represents a pixel unit L (1, 1) of an inverted triangle, which is composed of light-emitting components D (1, 1), D (1, 2), and D (2, 1), ⑫ represents a pixel unit L (1, 2) of a regular triangle, which is composed of light-emitting components D (2, 1), D (2, 1), and D (2, 2), and so on; and 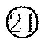
represents a pixel unit L (2, 1) of a regular triangle, which is composed of light-emitting components D (2, 1), D (3, 1), and D (3, 2), 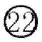 represents a pixel unit L (2, 2) of an inverted triangle, which is composed of light-emitting components D (2, 1), D (2, 2), and D (3, 2), and so on.

In the above arrangement of pixel units, the light-emitting component in the middle will be multiplexed by six adjacent pixel units. For example, the light-emitting component D (2, 3) is multiplexed by pixel units ⑫, ⑬, ⑭, 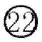 , 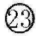 , and 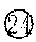 . The multiplexing number of the light-emitting component at an edge will be less than 6. For example, the light-emitting component D (1, 2) is only multiplexed by pixel units ⑪ and ⑫.

Embodiment 4: This embodiment describes a subpixel arrangement control method of a display panel. The control method is implemented for the subpixel arrangement structure according to embodiment 1, and the control method includes:
an image to be displayed is divided into corresponding pixel blocks according to distribution of pixel units of the display panel;
drive signals of light-emitting components with three primary colors in each pixel unit are acquired according to color and brightness of the pixel block corresponding to the pixel unit so that multiple drive signals of the light-emitting components to be multiplexed by multiple pixel units are provided, and an average value of the multiple drive signals is taken as an actual drive signal of the light-emitting component; and
all drive signals are transmitted by scanning to complete a display of an image.

The difference in this embodiment is that the scanning number is reduced, that is, one frame of driving image is used for one image, and the driving is completed by scanning once. For drive signals of the multiplexed light-emitting component, an average value of the drive signals of all pixel units multiplexing the light-emitting component is taken as a drive signal of the light-emitting component.

For example, referring to FIG. 2, the distribution mode of pixel units on the display panel is the same as that in embodiment 2, and a condition that the light-emitting component is multiplexed four times at most exists. Under this condition, a processing method of drive signals of the multiplexed light-emitting component is as follows:
referring to a region B in FIG. 2, a light-emitting component D (3, 6) is shared by four pixel units B1, B2, B3, and B4, and then, the drive signal of the light-emitting component is: an average value of a drive signal d (B1) of the light-emitting component in the drive signals of the pixel unit B1, a drive signal d (B2) of the light-emitting component in the drive signals of the pixel unit B2, a drive signal d (B3) of the light-emitting component in the drive signals of the pixel unit B3, and a drive signal d (B4) of the light-emitting component in the drive signals of the pixel unit B4 is taken as an actual drive signal d of the light-emitting component, where d=(d(B1)+d(B2)+d(B3)+d(B4))/4. The drive signal d (B1) of the light-emitting component in the drive signals of the pixel unit B1 refers to: a drive signal of the light-emitting component in the drive signals of the light-emitting components with three primary colors that form the pixel unit B1 determined according to color and brightness of the pixel unit B1 acquired by the corresponding pixel point in an image source.

The condition that the light-emitting component is multiplexed twice refers to a region A in FIG. 2. The light-emitting component D (2, 1) is shared by two pixel units A1 and A2, and then, the drive signal of the light-emitting component is: an average value of a drive signal d (A1) of the light-emitting component in the drive signals of the pixel unit A1 and a drive signal d (A2) of the light-emitting component in the drive signals of the pixel unit A2 is taken as a drive signal d of the light-emitting component, where d=(d(A1)+d(A2))/2.

Referring to FIG. 4 and FIG. 5, the distribution mode of pixel units on the display panel is the same as that in embodiment 3, and a condition that the light-emitting component is multiplexed six times at most exists. Under this condition, a processing method of drive signals of the multiplexed light-emitting component is as follows:
the drive signal of the light-emitting component D (3, 6) is an average value of the drive signals of the light-emitting component in pixel units C1, C2, C3, C4, C5, and C6. Specifically: an average value of a drive signal d (C1) of the light-emitting component in the pixel unit C1, a drive signal d (C2) of the light-emitting component in the pixel unit C2, a drive signal d (C3) of the light-emitting component in the pixel unit C3, a drive signal d (C4) of the light-emitting component in the pixel unit C4, a drive signal d (C5) of the light-emitting component in the pixel unit C5, and a drive signal d (C6) of the light-emitting component in the pixel unit C6 is taken as an actual drive signal d of the light-emitting component, where d=(d(C1)+d(C2)+d(C3)+d(C4)+d(C5)+d(C6))/6.

Embodiment 5: This embodiment describes a subpixel arrangement control system. The control system includes the display panel, a control unit and a drive unit, the display panel is of the subpixel arrangement structure according to claim 1, the drive unit is configured to perform display driving of the display panel according to a drive signal transmitted by the control unit, a module implemented by computer software is embedded inside the control unit, and the module includes:
an image collection module, configured to collect an image to be displayed;
a pixel block division module, configured to divide the image to be displayed into corresponding pixel blocks according to distribution of pixel units of the display panel;
a drive signal acquisition module, configured to acquire drive signals of light-emitting components with three primary colors in each pixel unit according to color and brightness of the pixel block corresponding to the pixel unit;
a multiplexed light-emitting component drive signal adjusting module, configured to take an average value of multiple drive signals corresponding to the light-emitting component multiplexed by multiple pixel units as an actual drive signal of the light-emitting component; and
a drive signal transmission module, configured to transmit all drive signals of the light-emitting components to the drive unit.

## Claims

1. A subpixel arrangement structure of a display panel, **characterized in that** the display panel is of an array structure composed of a plurality of light-emitting components, a distance between two adjacent light-emitting components in a same row is one basic unit, the light-emitting components in adjacent rows and a same column are staggered by a half basic unit, and the adjacent light-emitting components in any direction are light-emitting components with different primary colors, wherein
three adjacent light-emitting components with three primary colors form a pixel unit, and a condition that a plurality of pixel units multiplex a same light-emitting component exists.

2. The subpixel arrangement structure of the display panel according to claim 1, **characterized in that** the light-emitting component is a single illuminant or a combination of a plurality of illuminants with a same color.

3. The subpixel arrangement structure of the display panel according to claim 1, **characterized in that** the illuminant is any one of an LED, an OLED, or an LCD.

4. The subpixel arrangement structure of the display panel according to claim 1, **characterized in that** the light-emitting components in three adjacent rows form two rows of pixel units, and each pixel unit is a triangle composed of three light-emitting components with three primary colors in two adjacent rows, wherein one row of pixel units are regular triangles, and adjacent base angles of two adjacent triangles share one light-emitting component; the other row of pixel units are inverted triangles, and adjacent base angles of two adjacent triangle pixel units share one light-emitting component; and
vertex angles of each pixel unit of a regular triangle and an adjacent pixel unit of an inverted triangle in a previous row share one light-emitting component, and two base angles of the pixel unit of a regular triangle and a pixel unit of an inverted triangle in a next row respectively share one light-emitting component.

5. The subpixel arrangement structure of the display panel according to claim 1, **characterized in that** any adjacent light-emitting components with three primary colors form a pixel unit; and when the plurality of light-emitting components are arranged in i rows and j columns, pixel units in i rows and 2j columns are formed.

6. A subpixel arrangement control method of a display panel, **characterized in that** the control method is implemented for the subpixel arrangement structure according to claim 1, and the control method comprises:
dividing an image to be displayed into corresponding pixel blocks according to distribution of pixel units of the display panel;
acquiring drive signals of light-emitting components with three primary colors in each pixel unit according to color and brightness of the pixel block corresponding to the pixel unit so that a plurality of drive signals of the light-emitting components to be multiplexed by a plurality of pixel units are provided, and taking an average value of the plurality of drive signals as an actual drive signal of the light-emitting component; and
transmitting all drive signals by scanning to complete a display of an image.

7. A computer-readable storage medium, **characterized in that** the computer-readable storage medium is configured to store a computer program, and the computer program executes the subpixel arrangement method according to claim 6.

8. An electronic device, **characterized by** comprising a processor and a memory, wherein the memory is configured to store a computer program; and the processor is configured to implement the subpixel arrangement control method according to claim 6 when executing the computer program stored in the memory.

9. A subpixel arrangement control system, **characterized in that** the control system comprises the display panel, a control unit and a drive unit, the display panel is of the subpixel arrangement structure according to claim 1, the drive unit is configured to perform display driving of the display panel according to a drive signal transmitted by the control unit, a module implemented by computer software is embedded inside the control unit, and the module comprises:
an image collection module, configured to collect an image to be displayed;
a pixel block division module, configured to divide the image to be displayed into corresponding pixel blocks according to distribution of pixel units of the display panel;
a drive signal acquisition module, configured to acquire drive signals of light-emitting components with three primary colors in each pixel unit according to color and brightness of the pixel block corresponding to the pixel unit;
a multiplexed light-emitting component drive signal adjusting module, configured to take an average value of a plurality of drive signals corresponding to the light-emitting component multiplexed by a plurality of pixel units as an actual drive signal of the light-emitting component; and
a drive signal transmission module, configured to transmit all drive signals of the light-emitting components to the drive unit.
